# FASCICULE DE BREVET EUROPEEN

(11) **EP 0 858 256 B1**
(45) Date de publication et mention de la délivrance du brevet: **11.01.2006**
(21) Numéro de dépôt: 98500029.8
(22) Date de dépôt: 04.02.1998
(51) Int. Cl.: H05K 13/04

(54) **Perfectionnements sur les machines à insérer des composants**
Verbesserte Bauelementenbestückungsmaschine
Improvements to component insertion machines

(30) Priorité: 05.02.1997 ES 9700224
(43) Date de publication de la demande: 12.08.1998
(73) Titulaire: MECANISMOS AUXILIARES INDUSTRIALES S.A. M.A.I.S.A., E-43800 Valls, Tarragona (ES); Construcciones Mecanicas Jose Lazpiur, S.A., 43800 Valls, Tarragona (ES)
(72) Inventeur: Altes Puig, Josep, 43800 Valls (Tarragona) (ES); Lazpiur Lamariano, Miguel, 43800 Valls (Tarragona) (ES)
(74) Mandataire: Primo de Rivera y Urquijo, Jose A.

(56) Documents cités:
- EP-A- 0 090 050
- EP-A- 0 706 027
- FR-A- 2 520 183
- US-A- 4 667 403

## Description

La présente demande de brevets se rapporte à des "PERFECTIONNEMENTS SUR LES MACHINES À INSÉRER DES COMPOSANTS", dont les nouvelles caractéristiques de construction, conformation et conception remplissent la fonction pour laquelle ils ont été spécifiquement concus, avec un maximum de sécurité et d'efficacité.

Il existe sur le marché, et elles peuvent donc être considérées comme étant un état de la technique, divers types de machines dont la fonction principale consiste à exécuter la dénommée opération d'insertion ou encastrement dans des plaques de circuit imprimé, cette opération s'effectuant automatiquement ou semi-automatiquement mais toujours en tenant compte du fait que pour atteindre ce but il faut disposer de moyens de rotation sur le centre idéal de ce circuit imprimé pour permettre ainsi l'insertion entièrement automatique de certaines pièces. Dans tous les cas, la présence d'une personne spécialisée s'impose sur ce type de machines et d'opérations afin de changer le sens de la plaque de circuit imprimé et permettre ainsi que la machine à insérer travaille sur d'autres points auxquels elle ne pourrait pas accéder si l'on ne changeait pas le positionnement de la plaque de circuit imprimé. Dans d'autres cas, il existe des machines qui incorporent déjà cette caractéristique et il n'est donc pas nécessaire que l'ouvrier procède normalement au changement de la position du circuit imprimé.

Sur ce type de machines et pour atteindre un rendement optimum, il est indispensable d'alimenter et d'extraire les circuits imprimés de façon entièrement mécanique et, dans certains cas, manuelle, mais les machines présentes sur le marché exigent toujours le concours d'un dispositif de manutention qui se charge de prendre les circuits imprimés et de les introduire dans la machine et sur des bandes de transport qui ont pour mission d'alimenter le dispositif de manutention en circuits imprimés et de les recueillir lorsque l'opération d'insertion a été effectuée.

Ce type de disposition sur laquelle l'ensemble doit être formé par trois machines différentes (de manutention, à insérer et bandes de transport) complique énormément la régulation des différentes vitesses des machines qui composent l'ensemble, et de ce fait l'opération d'insertion, déjà complexe en soi, se prolonge excessivement, divers phénomènes bien connus se produisant alors ; en premier lieu un allongement du temps d'insertion des composants électriques et mécaniques sur la plaque de circuit imprimé, en deuxième lieu il est nécessaire de régler constamment la machine lorsque le type de circuit imprimé change. Pour cela, bien que sa fabrication ne soit pas impossible, il faut modifier les vitesses des trois éléments qui l'intègrent et la forme physique des parties en contact avec le circuit, c'est-à-dire la machine à insérer, le dispositif de manutention et les bandes de transport pour les adapter aux nouvelles caractéristiques du circuit imprimé, sur les faces duquel sont insérées les languettes correspondantes sur des guides, des pattes ou des ponts.

Certaines de ces machines (de manutention, à insérer et bandes de transport) sont décrites dans brevet ES n° 9001692. Sur ce type de machines, la tête automatique est spécialement importante pour l'insertion de pattes, de ponts de connexion et de douilles sur les plaques de circuit imprimé, auxquelles il est fait référence dans d'autres registres, comme les brevets ES nº 9000931, 9000966 et 9001629, dans lesquelles sont décrits et revendiqués différents types de têtes pour travailler sur les machines à insérer des composants sur des circuits imprimés.

Les perfectionnements indiqués par l'objet de la présente invention consistent à intégrer les trois éléments qui forment l'ensemble, c'est-à-dire la machine à insérer, le dispositif de manutention et les bandes de transport, dans une seule machine, de sorte que lesdites bandes de transport constituent des parties de la machine, le dispositif de manutention qui est chargé d'introduire le circuit imprimé et de le poser dans la machine a été supprimé et celui-ci a été remplacé par d'autres dispositifs permettant que toutes les fonctions de l'ensemble soient automatiques et que la machine puisse travailler en changeant et en continu avec différents types de circuit imprimé ; cette dernière comprend également les dispositifs électroniques nécessaires pour que tous les circuits imprimés fabriqués par l'ensemble possèdent la propriété dite de traçabilité, sollicitée par la plupart des fabricants d'automobiles, qui permette la lecture sur la machine à insérer des circuits imprimés de sorte que pour chacun d'entre eux l'on puisse identifier la machine qui l'a fabriqué et détecter ensuite plus aisément les défaillances éventuelles ou les améliorations possibles, le tout conformément aux nouvelles exigences du marché de l'automobile qui exige, chaque jour davantage, des standards de qualité et de fiabilité toujours plus élevés, en introduisant sur ceux-ci et sur les véhicules similaires une série de dispositifs qui permettent d'apporter non seulement la sécurité dans le fonctionnement de l'automobile, mais qui offrent également à l'usager une série de commodités et de prestations qui finalement présentent l'avantage que cet usager peut être davantage disponible pour la conduite et en augmenter par-là la sécurité.

En définitive, la machine à insérer perfectionnée qui est décrite ci-dessous réunit donc en elle-même les fonctions des précédentes machines à insérer existantes sur le marché, celle des éléments de manutention annexes à celles-ci, ainsi que les éléments de transport qui permettaient d'introduire et de retirer les différents circuits imprimés à la surface desquels il était possible d'en insérer les différents composants électroniques.

La machine selon l'invention est ainsi essentiellement formée d'un banc conventionnel sur lequel se trouvent ses principaux éléments qui sont entourés d'un paravent. Comme éléments complémentaires à la machine, on place d'une manière déjà connue un support de tête d'insertion, à la façon du cou d'un cygne, de sorte que cette tête soit située dans la partie supérieure de la machine et autour de la table de coordonnées ; dans l'une des parties latérales, on installe une armoire électrique dans laquelle sont centralisés tous les dispositifs, aussi bien électriques qu'électroniques, qui gouvernent la machine en combinaison avec un ordinateur conventionnel et un pupitre de commandes avec les différentes fonctions que doit exécuter la machine. Au-dessus du banc et au-dessous de la table de coordonnées se trouvent deux bandes de transport construites sur la base des rampes correspondantes ; ces dernières permettent de soutenir les différentes parties connues et conventionnelles des bandes de transport, incorporant dans la partie inférieure de cette bande des parties novatrices et originales des présents perfectionnements qui consistent, pour chacun des élévateurs dont la fonction est de recevoir les circuits imprimés des bandes de transport, à les élever au bon moment et sur les points appropriés jusque sur le plateau tournant de la table de coordonnées et de les mettre au niveau de cette table.

La table de coordonnées de la machine est actionnée par des moyens correspondants, également conventionnels, qui sont en l'occurrence matérialisés par des rampes situées dans la partie inférieure de cette table et servent d'éléments de guidage à des moyens de roulement, permettant ainsi l'avance et le recul des coordonnées sur cette table ; cette dernière comprend, sur l'une de ses extrémités, un plateau tournant sur la partie centrale duquel se trouve la zone de travail ou de réception des plaques de circuit imprimé proprement dite, les plaques étant fournies par ces élévateurs.

D'autres détails et caractéristiques de la présente demande seront décrits dans la description ci-dessous, dans laquelle il est, fait référence aux détails qui sont joints à cet exposé où il convient de mettre l'accent sur le fait que les perfectionnements ne se limitent pas à la tête d'insertion ni à la contre-bouterolle située en ligne avec cette tête et placée sur le côté opposé, c'est-à-dire en position inférieure à la table de coordonnées.

Nous indiquerons ci-dessous les divers éléments indiqués sur les figures jointes à la description: (10) machine, (11) paravent, (12) pieds réglables, (13) support, (14) rouleau, (15) têtes d'insertion, (16) support de têtes d'insertion, (17) bandes de transport, (18) banc, (19) entrée de palettes, (20) sortie de palettes, (21) table de coordonnées, (22) zone de travail, (23) pupitre de commande, (24) pupitre, (25) support de coupeur, (27) plateau tournant, (28) éléments de fixation, (29) bande support du circuit imprimé, (30) pistons pneumatiques hydrauliques, (31) rampes de guidage, (32) moyens de roulement, (33) contre-bouterolle, (34) élévateurs de palettes, (35) palette, (36) rampes, (37) guides ou profils, (38) guides ou profils, (39) codificateur, (40) protection du moteur, (41) levier de fixation, (42) éléments de roulement, (43) couloir en forme de U, (44) cliquet, (45) cylindre, (46) trou, (46a) platine.

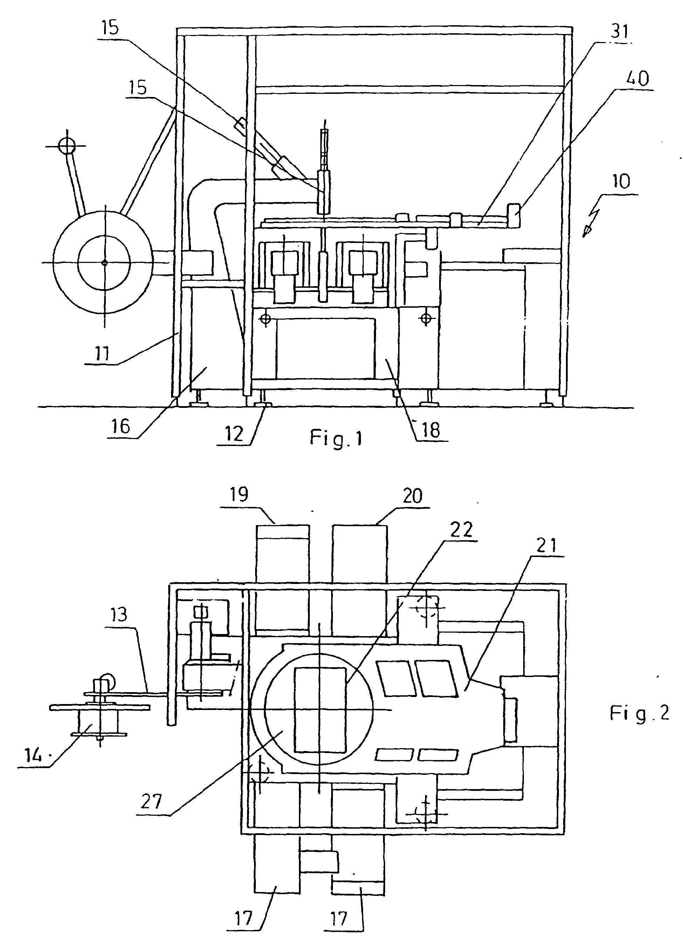

La figure 1 est une vue en élévation frontale de la machine (10) objet de l'invention, sur laquelle on peut voir la plupart des éléments, tels que le paravent (11) qui entoure pratiquement toute la machine (10), le support (16) de tête (15) d'insertion, à la façon d'un cou de cygne, la tête d'insertion (15) proprement dite, une plate-forme (21) ou une table de coordonnées, une zone de travail (22) de périmètre rectangulaire et qui est située dans la zone centrale du plateau tournant (27), le tout reposant sur le banc (18) sur des pieds réglables conventionnels (12).

La figure 2 est une vue supérieure en coupe de cette machine, sur laquelle on peut voir, outre les éléments expliqués sur la figure précédente, le rouleau (14) d'alimentation de languettes, douilles ou similaires, ainsi que les entrées et les sorties de palettes (19) et (20), situées perpendiculairement à la table de coordonnées (21).

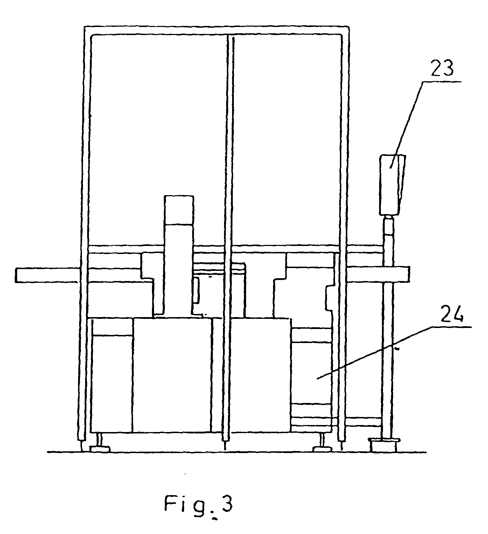

La figure 3 est une vue postérieure de cette machine (10) sur laquelle on distingue comment par le biais d'un support conventionnel est placé un pupitre de commande (23) sur lequel l'usager intervient et qui transmet les ordres à un ordinateur conventionnel et de celui-ci à l'armoire (24), les signaux partant de celui-ci et de façon centralisée vers tous les organes de la machine (10).

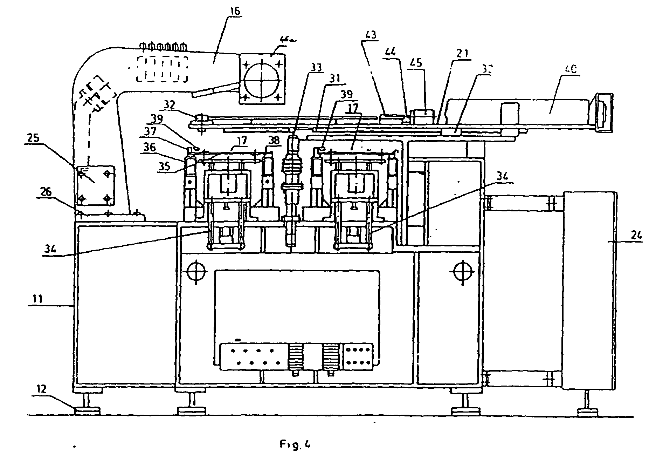

La figure 4 est une vue frontale partiellement sectionnée de cette machine (10), sur laquelle on peut voir plus en détail les différents éléments qui ont été énumérés à la description de la figure 1, mais exécutée à une plus grande échelle l'on distingue très nettement le positionnement des élévateurs de palettes (34), dont la fonction est de placer les circuits imprimés sur la surface des bandes de transport (17), pour ensuite placer les circuits imprimés à l'intérieur de la zone de travail (22) du plateau giratoire (27).

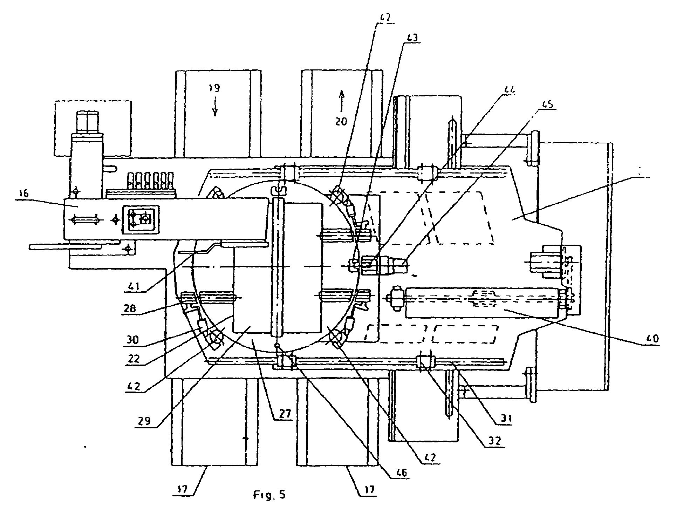

La figure 5 est une vue supérieure en coupe de cette machine (10), sur laquelle on peut voir en détail les mécanismes tant de mouvement que de la plate-forme (21) ou de la table de coordonnées, les moyens de fixation du plateau tournant (27), ainsi que les moyens qui permettent le mouvement de roulement de ce plateau (27) par rapport à la table (21) et les éléments qui permettent le mouvement de la table (21) par l'action du cylindre (40).

Dans l'un des modes de réalisations préférés de l'objet de la présente demande de brevet et, comme on peut le voir sur les figures nº 1, 2 et 3, la machine (10) comprend sur un seul ensemble la fonction d'insertion exécutée au travers des têtes (15) (voir la figure nº 1) montés sur des supports à la façon d'un cou de cygne (16), ainsi que les bandes de transport (17), (voir la figure nº 2) lesquelles présentent les sens d'avance qui sont marqués sur la figure nº 5, étant située sur la gauche (19) de la figure nº 2, celle de l'alimentation en circuits imprimés de la machine à insérer, et sur la droite (20) celle de transport une fois insérés sur le circuit tous les composants fournis par le rouleau (14), dans tous les cas les bandes (19) sont préparées pour travailler indistinctement dans le sens inverse.

Lors de la conception de la machine (10) l'on a intégré les fonctions d'insertion, d'alimentation automatique de circuits imprimés bien que leur format soit différent de la machine (10), transport des circuits imprimés avec tous les composants déjà insérés au moyen des bandes de transport (17) et suppression de tout type de dispositif de manutention de ceux-ci, ces derniers étant remplacés par de simples élévateurs de palettes (34) dont le fonctionnement est décrit plus loin. Dans un autre ordre technique, les têtes d'insertion (15) sont facilement remplaçables par d'autres montées sur la platine (46), voir la figure nº 4, ou immobilisés à l'aide du levier (41).

Lors de la construction de la machine, en plus d'intégrer les trois éléments qui, selon l'état de la technique, étaient fabriqués séparément et constituaient les unités indépendantes susmentionnées, l'on a réuni toutes les fonctions électriques et électroniques sur un seul élément ; pour cela, l'on incorpore au banc de la machine (18) un pupitre (24) sur lequel sont centralisés tous les éléments de celui-ci, tant électriques qu'électroniques, qui reçoivent les signaux correspondants d'un ordinateur conventionnel situé sur la partie postérieure de (24) et permettant, depuis l'extérieur des paravents (11) qui entourent la machine (10) et au travers d'un simple pupitre de commande (23), à l'usager, de la machine de la gouverner sans besoin d'aide mannuelle pour tout type d'opération ou de changement de format du circuit imprimé.

Comme le montre la figure 4, sur le banc (18) qui repose sur les pieds réglables (12), l'on a monté des élévateurs de palettes (34) situés sur la partie inférieure centrale des bandes de transport (17), lesquelles sont montées sur les supports correspondants situés au-dessus du banc (18) et sur les rampes elles-mêmes (36) situées parallèlement les unes aux autres, montées à la gauche de la contre-bouterolle (33), et deux à la droite de celle-ci.

Sur les rampes (36) sont situés des guides ou des profils (37) et (38), dont la mission est d'aider et de guider l'entraînement et le mouvement des moyens dont disposent les bandes de transport (17) pour remplir leur mission ; sur le profil gauche (37) est situé un codificateur (39) dont la fonction est de lire, au travers du circuit situé à proximité, les opérations que doit effectuer la tête (15) montée sur l'extrémité libre du cou de cygne (16), qui est à son tour monté sur le banc (18) à l'aide de platines conventionnelles (25) et (26) et en s'aidant pour cela du levier de fixation (41) correspondant, également situé près de l'extrémité libre de (16).

La fonction des élévateurs de palette (34) est de placer les circuits imprimés situés sur la partie supérieure des bandes de transport dans la surface ou zone de travail (22), où sont réceptionnées les plaques lorsqu'elles sont recueillies par l'élévateur (34) de la bande (17) ; à ce moment-là (voir également la figure nº 5) la zone de travail est alignée avec le périmètre du circuit imprimé, des dispositifs de fixation pneumatiques (30) agissant de façon simultanée et entièrement automatique et fixant le circuit imprimé élevé par (34) sur le plateau tournant (27).

Le plateau tournant (27) présente dans sa zone centrale une ouverture rectangulaire délimitée par la surface ou périmètre de travail (22), et qui reçoit le mouvement par le biais de moyens conventionnels ou d'éléments de roulement (42), lesquels permettent la rotation du plateau (27), la surface latérale de (27) étant en contact avec les éléments de roulement (42). La combinaison des mouvements du plateau giratoire (21) permet les mouvements nécessaires pour que la tête d'insertion (15) puisse agir sur tous les points de la plaque de circuit imprimé fixée à l'intérieur de la zone de travail ou de réception des plaques (22), outre les éléments de fixation (28) actionnés par les pistons (30) et sur la partie droite du plateau (27) un couloir en forme de U (43) est immobilisé et sa fonction est d'emboîter un cliquet (44) impulsé par un cylindre (45), et l'on achève donc l'opération d'immobilisation de ce plateau (27) par les moyens décrits précédemment.

La table de coordonnées (21) marque un mouvement de gauche à droite et de droite à gauche et du nord au sud, et inversement, au travers de moyens constitués de quelques rampes de guidage (31) solidarisées à leur base inférieure et par lesquelles circulent des éléments de roulement (32) qui permettent le déplacement de (21) grâce à l'action du moteur (40), en combinaison avec un goujon qui n'est pas représenté sur les figures et dont l'extrémité supérieure vient mourir dans le trou (46), obligeant le mouvement de ce goujon, celui de la masse (21).

Lorsque la tête d'insertion (15) montée sur l'extrémité libre du cou de cygne (16) a exécuté toutes ses fonctions d'une façon entièrement automatique et avec la démobilisation du plateau tournant (27), par les moyens susmentionnés et à l'aide des moyens de mouvement de la plate-forme ou table de coordonnées (21) précédemment décrits, on laisse le circuit imprimé sur la bande de transport (17) et à l'aide de l'élévateur de palette (34) préalablement situé sur la partie ou base inférieure du circuit imprimé, avec les composants déjà insérés, et replacés sur cette bande de transport (17), sortant en direction de (20).

La combinaison des bandes (17), à l'entrée et à la sortie signalées par les flèches (19) et (20) sur la figure 4 avec le codificateur (39) permet, en premier lieu, lorsque l'on reçoit le circuit imprimé correspondant au travers de la bande (17) d'entrée, à celui-ci (39) de lire les caractéristiques de ce circuit et de les remettre à l'ordinateur correspondant, lequel, à l'aide de l'armoire (24) et des ordres introduits par l'usager dans le pupitre (23), exécute tout le cycle opératif décrit précédemment, quelles que soient les dimensions ou les caractéristiques de la plaque, permettant en outre de satisfaire une exigence expliquée dans la première partie de la description et qui est celle de la traçabilité du circuit fabriqué, c'est-à-dire les possibilités d'incorporer un signal sur celle-ci qui permette d'identifier ensuite sur quelle machine elle a été fabriquée.

Tout cela, avec les fonctions du cycle opératif précédemment décrit, d'une façon entièrement automatique et sans intervention mannuelle de l'opérateur lors des différentes opérations et fonctions des machines.

## Revendications

1. Machine à insérer des composants, comprenant une table de coordonnées (21) en combinaison avec une tête d'insertion (15) montée sur l'extrémité libre d'un support en forme de cou de cygne (16), destiné à insérer sur la face supérieure d'un circuit imprimé des douilles, languettes, ponts et éléments similaires correspondants, tant électriques qu'électroniques qui sont fournis à ladite tête d'insertion (15) partant d'un rouleau (14) supportée sur le banc (18) de la machine, **caractérisée en ce que** la machine comporte des bandes de transport (17) d'entrée (19) et de sortie (20) pour des palettes ainsi que des moyens automatiques:
- d'insertion desdits composants à l'aide de ladite tête d'insertion (15);
- d'incorporation à la table de coordonnées (21) des circuits imprimés sur la face supérieure desquels on souhaite insérer lesdits composants, constitués par des élévateurs de palettes (34) situés sur les parties inférieures desdites bandes de transport (17), chaque élévateur portant un codificateur (39) permettant de lire sur les circuits imprimés les donnés de commande de la tête d'insertion et du plateau tournant (27) et
- de transport du circuit imprimé avec les composants insérés sur une bande de transport.

2. Machine, selon la revendication 1, **caractérisée en ce que** la machine (10) incorpore sur son banc (18) une armoire électrique-électronique (24) dans laquelle se trouve la totalité des éléments électriques et éledroniques de commande (10) qui reçoivent les instructions d'un ordinateur conventionnel et d'un pupitre de commande (23) situé sur la partie inférieure de la machine (10) et à proximité des paravents (11) qui l' entourent, lesdites bandes de transport (17) étant placées au-dessus de supports parallèles et longitudinaux montés au-dessus du banc (18) et de quelques rampes (36) sur lesquelles sont situés, à droite, des profils et des guides (38) et à gauche, des profils de guidage (37), lesdits codificateurs (39) étant montés sur ces profils (37).

3. Machine selon une des revendications précédentes, **caractérisée en ce que** lesdits élévateurs de palettes (34) qui retirent les circuits imprimés situés sur la bande de transport (17) et les placent dans une zone ou périmètre de travail rectangulaire (22) du plateau tournant (27), se trouvent sur la partie inférieure des bandes de transport (17) et montés sur le banc (18).

4. Machine selon une des revendications précédentes, **caractérisée en ce que** le plateau tournant (27) est adapté pour immobiliser le circuit imprimé transporté par les élévateurs (34) au moyen de dispositifs de fixation pneumatiques ou hydrauliques (28), équipés de pistons hydrauliques ou pneumatiques (30), le plateau (27) étant immobilisé à la table (21) à l'aide d'un couloir en U (43) monté sur la partie supérieure du plateau (27), formé d'un profil en U qui est muni d'un cliquet (44) actionné pneumatiquement au moyen d'un cylindre (45) monté sur la partie supérieure de la table (21).

5. Machine selon une des revendications précédentes, **caractérisée en ce que** la table de coordonnées (21) se déplace à droite et à gauche de la machine (10) par des moyens formés par quelques rampes de guidage solidarisées à leurs plus grandes bases et placées dans la partie inférieure de ladite table (21) et quelques moyens de roulement (32) associés à un moteur (40) et permettant le mouvement de la table (21).

## Patentansprüche

1. Maschine zum Einfügen von Komponenten, die aus einem Koordinatentisch (21) in Kombination mit einem Einlasskopf (15), der auf dem freien Ende einer schwanenhalsförmigen Halterung (16) montiert ist, besteht, die bestimmt ist, auf der Oberseite einer gedruckten Schaltung Hülsen, Laschen, Brücken und ähnliche entsprechende elektrische und elektronische Elemente einzufügen, die sich an dem genannten Einlasskopf (15) befinden, und zwar ausgehend von einer Walze (14), die auf der Maschinenbank (18) aufliegt, **dadurch gekennzeichnet, dass** die Maschine Förderbänder (17) zum Eingang (19) und Ausgang (20) von Paletten sowie für automatische Mittel aufweist,
- die dem Einlassen der genannten Komponenten mit Hilfe des genannten Einlasskopfes (15) dienen;
- die dem Einlassen der gedruckten Schaltungen, auf deren Oberseite die genannten Komponenten eingelassen werden sollen, in den Koordinatentisch (21) dienen und die aus Palettenhebern (34) bestehen, die sich auf den unteren Teilen der genannten Förderbänder (17) befinden, wobei jeder Heber einen Codierer (39) aufweist, mit dem er die Steuerdaten auf den gedruckten Schaltungen für den Einlasskopf (15) und für die drehbare Schale (27) einlesen kann; und
- die dem Transport der gedruckten Schaltung mit den eingelassenen Komponenten auf einem Förderband dienen.

2. Maschine nach Anspruch 1, **dadurch gekennzeichnet, dass** in der Bank (18) der Maschine (10) ein elektrisch-elektronischer Schrank (24) integriert ist, in dem sich alle elektrischen und elektronischen Steuerelemente (10) befinden, die Anweisungen von einem herkömmlichen Computer und von einem Steuerpult (23) erhalten, das sich auf dem unteren Teil der Maschine (10) und in der Nähe der Trennwände (11), die sie umgeben, befindet, wobei die genannten Förderbänder (17) sich auf parallel und längs verlaufenden Trägern befinden, die auf der Bank (18) und auf Rampen (36) eingebaut sind, auf denen rechts Profile und Schienen (18) und links Leitprofile (37) angebracht sind, wobei die genannten Codierer (39) auf den Profilen (37) eingebaut sind.

3. Maschine nach einer der vorhergehenden Ansprüche, **dadurch gekennzeichnet, dass** die genannten Palettenheber (34), die die gedruckten Schaltungen vom Förderband (17) nehmen und sie auf einen rechteckigen Arbeitsbereich oder -gebiet (22) der drehbaren Schale (27) legen, sich auf dem unteren Teil der Förderbänder (17) und auf der Bank (18) montiert befinden.

4. Maschine nach einer der vorhergehenden Ansprüche, **dadurch gekennzeichnet, dass** die drehbare Schale (27) so ausgerichtet ist, dass sie die gedruckte Schaltung, die von den Hebern (34) befördert wird, mithilfe von pneumatischen oder hydraulischen Arretiervorrichtungen (28), die mit hydraulischen oder pneumatischen Kolben (30) versehen sind, feststellen kann, wobei die Schale (27) mithilfe eines U-förmigen Stifts (43), der am oberen Teil der Schale (27) montiert ist, und aus einem U-förmigen Profil besteht, das mit einer Sperrvorrichtung (44) versehen ist, die pneumatisch mithilfe eines Zylinders (45) ausgelöst wird, der auf dem oberen Teil des Tisches (21) eingebaut ist, am Tisch (21) befestigt ist.

5. Maschine nach einer der vorhergehenden Ansprüche, **dadurch gekennzeichnet, dass** der Koordinatentisch (21) sich nach rechts und links von der Maschine (10) mithilfe von Mitteln verschiebt, die aus Leitrampen, die fest mit ihren größeren Sockeln verbunden sind und sich im unteren Teil des genanntem Tisches (21) befinden, sowie aus Rollmitteln (32), die mit einem Motor (40) verknüpft sind und die Bewegung des Tisches (21) ermöglichen, bestehen.

## Claims

1. A machine for inserting components comprising a coordinate table (21) in combination with an insertion head (15) assembled on the free end of a swan neck-shaped support (16), intended for inserting on the upper side of a printed circuit the corresponding bushings, tongues, bridges and similar elements, both electrical and electronic, provided to said insertion head (15), starting from a roller (14) supported on the machine bench (18), **characterised in that** the machine includes inlet (19) and outlet (20) conveyor belts (17) for palettes as well as automatic means:
- for inserting said components with the aid of said insertion head (15);
- for incorporating on the coordinate table (21) the printed circuits on the upper side of which said components are to be inserted, constituted by palette elevators (34) located on the lower portions of said conveyor belts (17), each elevator having an encoder (39) allowing it to read from the printed circuits the control data for the insertion head (15) and for the rotary tray (27) and
- for transporting the printed circuit with the inserted components on a conveyor belt.

2. A machine according to claim 1, **characterised in that** the machine (10) has incorporated on its bench (18) an electrical-electronic cabinet (24) in which all the electrical and electronic control elements (10) are inserted, receiving instructions from a conventional computer and a control station (23) located on the lower portion of the machine (10) and close to the screens (11) which surround it, said conveyor belts (17) being placed on parallel and longitudinal supports assembled above the bench (18) and on some ramps (36) on the right side of which profiles and guides (38) are placed, and, on the left side, guide profiles (37), said encoders (39) being assembled on these profiles (37).

3. A machine according to one of the previous claims, **characterised in that** said palette elevators (34) removing the printed circuits located on the conveyor belt (17) and placing them in a rectangular work area or perimeter (22) of the rotary tray (27), are on the lower portion of the conveyor belts (17) and assembled on the bench (18).

4. A machine according to one of the previous claims, **characterised in that** the rotary tray (27) is adapted to immobilise the printed circuit that is transported by the elevators (34) by means of pneumatic or hydraulic fixing devices (28) provided with hydraulic or pneumatic pistons (30), the tray (27) being immobilized to the table (21) with the aid of a U-shaped passage (43) assembled on the upper part of the tray (27), formed by a U profile provided with a ratchet (44) actuated pneumatically by means of a cylinder (45) assembled on the upper portion of the table(21).

5. A machine according to one of the previous claims, **characterised in that** the coordinate table (21) shifts towards the left and the right sides of the machine (10) by means formed from guide rails integral with their largest bases and placed on the lower part of said table (21) and some rolling means (32) associated to a motor (40) and which allow the movement of the table (21).
